Europäisches Patentamt

European Patent Office

Office européen des brevets

(11) Veröffentlichungsnummer: **0 315 762 B1**

(12) **EUROPÄISCHE PATENTSCHRIFT**

(45) Veröffentlichungstag der Patentschrift: **29.07.92**

(21) Anmeldenummer: **88115396.9**

(22) Anmeldetag: **20.09.88**

(51) Int. Cl.⁵: **B23K 1/00**, H05K 3/34

(54) **Durchlaufofen zum Anlöten von elektronischen Bauteilen.**

(30) Priorität: **07.11.87 DE 3738136**

(43) Veröffentlichungstag der Anmeldung:
**17.05.89 Patentblatt 89/20**

(45) Bekanntmachung des Hinweises auf die
Patenterteilung:
**29.07.92 Patentblatt 92/31**

(84) Benannte Vertragsstaaten:
**AT BE CH DE ES FR GB IT LI NL SE**

(56) Entgegenhaltungen:
**WO-A-85/03248**

(73) Patentinhaber: **Heraeus Ouarzglas GmbH
Ouarzstrasse Postfach 1554
W-6450 Hanau(DE)**

(72) Erfinder: **Mittelstädt, Norbert
Gerhard-Hauptmann-Strasse 4
W-6450 Hanau(DE)**

(74) Vertreter: **Grimm, Ekkehard
Heraeus Ouarzglas GmbH Ouarzstrasse
Postfach 1554
W-6450 Hanau(DE)**

**Beschreibung**

Die vorliegende Erfindung betrifft einen Durchlaufofen zum Anlöten von elektronischen Bauteilen auf Leiterplatten mit einem Transportband, das Auflageelemente für die Leiterplatten aufweist, wobei entlang des Transportbandes oberhalb und/oder unterhalb der Bandlaufebene Infrarot-Strahler mit Abstand angeordnet sind, die mehrere Aufheizzonen und, in Richtung des Bandlaufes gesehen, hinter diesen Zonen, einer Lötzone zugeordnet sind, und mit einer Kühlzone.

Solche Durchlauföfen, die auch als Infrarot-Durchlauföfen für die Oberflächenmontage von SMD-Bauteilen (Surface Mounted Device) bezeichnet werden, sind allgemein bekannt. In der WO-A-8503248 ist ein Durchlaufofen zum Anlöten von elektronischen Bauteilen auf Leiterplatten beschrieben, der ein Transportband zum Transportieren der Leiterplatten durch den Durchlaufofen aufweist. Dabei durchlaufen die Leiterplatten eine Vorheizzone und werden in mehreren aufeinanderfolgenden Heizzonen stufenweise aufgeheizt, bis sie die Lötzone erreichen. Daraufhin werden die Leiterplatten zu einer Abkühlzone transportiert, wo die Bauteile zur Entnahme aus dem Ofen abgekühlt werden. Zwischen der Vorheizzone und den Heizzonen befindet sich eine weitere Zone mit einer Entlüftungsöffnung oberhalb der ein Ventilator angeordnet ist, der einen Luftstrom durch die Lüftungsöffnung verursacht. Durch diesen Luftstrom werden Gase, die durch die Eintrittsöffnung und durch die Austrittsöffnung des Transportbandes in den Ofen gelangen, sowie Gase, die während des Aufheiz- und Lötprozesses entstehen, abgeleitet. Dabei strömt der Gasstrom innerhalb des Ofens im wesentlichen parallel zur Oberfläche des Transportbandes. Unter der Bezeichnung "Panasert-REF - Dual Side Heating Reflow Solding and Curing Oven" ist auch ein Ofen mit einem Transportband bekannt, auf das Leiterplatten aufgelegt werden, um sie durch den Ofen zu fahren. Oberhalb und/oder unterhalb dieses Transportbandes sind Infrarot-Strahler angeordnet in Form von Röhren oder Heizplatten, um die mit elektronischen Bauteilen bestückten Leiterplatten zu verlöten. Die Beheizung durch die Infrarot-Strahler ist in mehrere Heizzonen unterteilt, die mit unterschiedlichen Heizleistungen betrieben werden, um das Lot zum Anlöten der Bauteile auf die erforderliche Löttemperatur kontinuierlich aufzuheizen.

Messungen an Bauteilen, die an den Leiterplatten anzulöten sind, haben ergeben, daß große Bauteile sich langsamer aufwärmen als kleine Bauteile, die sich nur geringfügig von der Leiterplatte erheben und deren Wärmekapazität aufgrund der geringeren Größe weitaus geringer ist. Dies kann zu einer erhöhten Beanspruchung der kleinen Bauteile führen. In der Lötstation ergeben sich hierdurch Temperaturunterschiede zwischen dem Gehäuse eines großen Bauteils, wie ein Chip-PLCC 64, und einem Transistor, die bei 40 °C bis 45 °C liegen. Diese hohen Temperaturunterschiede zwischen den einzelnen Bauteilen in der Lötzone führen dazu, daß kleine Bauteile überhitzt und übermäßig beansprucht werden, während die großen Bauteile im Bereich ihrer Anschlußstellen eine Temperatur geringfügig oberhalb der Löttemperatur erreichen; die erforderliche Löttemperatur liegt für Lötzinn bei etwa 180 °C bis 185 °C.

Der vorliegenden Erfindung liegt nun die Aufgabe zugrunde, einen Durchlaufofen der eingangs beschriebenen Art derart weiterzubilden, daß die Temperatur zwischen großen und kleinen auf einer Leiterplatte anzulötetenden Bauteilen im Bereich der Lötzone gegenüber herkömmlichen Öfen weiter angenähert wird.

Diese Aufgabe wird bei einem Durchlaufofen der beschriebenen Art dadurch gelöst, daß zwischen der letzten Aufheizzone und der Lötzone die Kühlzone angeordnet ist, in der eine Zwangskühlung mit einem gasförmigen Kühlmedium erfolgt, das mittels eines Gebläses durch in der Kühlzone angeordnete Düsen im wesentlichen senkrecht zur Ebene des Transportbandes strömt. Durch diese Maßnahme werden die Leiterplatten nach dem anfänglichen Aufheizen, bevor sie in die Lötzone eintreten, zwangsgekühlt. Diese Kühlung bewirkt, daß sich die kleinen Bauteile auf der Leiterplatte schneller abkühlen als die großen Bauteile, die aufgrund ihrer hohen Wärmekapazität ohnehin auf eine geringere Temperatur aufgeheizt sind. Die kleinen Bauteile, die in dem Bereich vor der Lötzone bereits eine Temperatur nahe der Löttemperatur aufweisen, werden in ihrer Temperatur den großen Bauteilen angenähert, bevor sie in die Lötzone einfahren. Messungen haben ergeben, daß durch diese Zwangskühlung die großen Chip-PLCC 64 und die kleinen Transistoren (die gemessenen Chip-PLCC 64 wiesen eine etwa 400-fach größere Masse auf als die Transistoren) vor der Lötzone praktisch auf eine gleiche Temperatur gebracht werden können. In der Lötzone kann als Folge dieser Temperaturangleichung vor der Lötzone eine um mindestens 10° bessere Temperaturannäherung der kleinen Bauteile an die großen Bauteile gegenüber herkömmlichen Öfen erzielt werden, d.h. zwischen diesen Bauteilen ist eine Temperaturdifferenz von etwa 20 bis 30 °C festzustellen. Durch diese Temperaturannäherung werden die kleinen Bauteile weniger gestreßt, d.h. thermisch beansprucht und die Gesamt- heizzeit gleichzeitig auf ein Mindestmaß, je nach Masse des Bauteils, auf maximal 3,5 Minuten verkürzt.

Eine langsame Temperaturannäherung während des Aufheizens der Leiterplatten kann dadurch begünstigt werden, daß in Bandlaufrichtung gesehen vor der Lötzone mehrere Aufheizzonen vorgesehen sind, die durch zwangsgekühlte Zonen voneinander getrennt sind. Zwischen den einzelnen Aufheizvorgängen werden die kleinen Bauteile jeweils schneller abgekühlt als die großen Bauteile, so daß sich die Bauteile zwar langsam in den einzelnen Aufheizzonen aufheizen, jedoch die Temperaturdifferenz zwischen den unterschiedlich großen Bauteilen gering gehalten wird. Bevorzugt werden zwei Aufheizzonen vorgesehen, die durch eine zusätzliche Kühlzone, die zwangsgekühlt wird, voneinander getrennt sind.

Eine zusätzliche Kühlung in der Lötzone kann von Vorteil sein, um einen zu großen Temperaturanstieg in der Lötzone zu vermeiden. Infolge einer solchen Zwangskühlung der Lötzone wird das Temperaturprofil abgeflacht, so daß die Löttemperatur über einen längeren Bereich, in dem die Lötung erfolgt, angenähert ist und der Temperaturunterschied zwischen großen und kleinen Bauteilen auf ein Minimum begrenzt wird.

Als Kühlmedium wird bevorzugt Luft eingesetzt, die über einen Luftverteilungsraum unterhalb und/oder oberhalb des Transportbandes auf die einzelnen Kühlzonen und die Lötzone verteilt wird. Um eine gerichtete Strömung zu erreichen, wird die Kühlluft über Düsen auf das Transportband und die darauf aufgelegten Leiterplatten zugeführt. In sehr einfacher Weise können solche Düsen durch U-Profile gebildet werden, die mit Abstand und parallel zueinander quer zur Laufrichtung des Transportbandes angeordnet sind. Zwischen den benachbarten Schenkeln dieser U-Profile wird eine laminare Strömung der Kühlluft erzeugt. Als vorteilhaft hat sich eine lichte Weite zwischen benachbarten Schenkeln (Düsenspalt) von 1 bis 3 mm erwiesen. Die Länge der Schenkel der U-Profile liegt bevorzugt zwischen 40 und 70 mm, der mittlere Abstand benachbarter Düsenöffnungen bzw. Düsenspalte zwischen 50 und 80 mm.

Mit dem angegebenen Durchlaufofen, der beispielsweise zwei Aufheizzonen mit einer dazwischen geschalteten Kühlzone aufweist, können Durchlaufgeschwindigkeiten des Transportbandes von 0,6 m/min bis 1 m/min, bevorzugt von etwa 0,8 m/min, gefahren werden. Insbesondere bei diesen Geschwindigkeiten sollten die Energiedichten der Infrarot-Strahler in der ersten Aufheizzone etwa 3,5 bis 4,5 W/cm², in der zweiten Aufheizzone 2 etwa 3 W/cm² und in der Lötzone 5 bis 6 W/cm² betragen. Um die Lötzone sehr kurz halten zu können, werden in diesem Bereich bevorzugt mittelwellige und/oder kurzwellige Infrarot-Strahler eingesetzt, die sich durch eine im Vergleich zu langwelligen Infrarot-Strahlern höhere Energiedichte auszeichnen.

Eine zusätzliche Kühlzone im Anschluß an die Lötzone kann dazu dienen, die Bauteile, bevor sie dem Durchlaufofen entnommen werden, ausreichend abzukühlen.

In der ersten und der zweiten Kühlzone können einzelne Infrarot-Strahler eingesetzt werden, die gegegebenenfalls getrennt von den Infrarot-Strahlern der Aufheizzone betrieben werden, um, auch in Abhängigkeit der anzulötenden Bauteile, einem zu schnellen Abkühlen entgegenzuwirken.

Weitere Einzelheiten und Merkmale der Erfindung ergeben sich aus der nachfolgenden Beschreibung eines Ausführungsbeispiels anhand der Zeichnung. In der Zeichnung zeigt

Figur 1    schematisch einen Längsschnitt durch einen erfindungsgemäßen Banddurchlaufofen und

Figur 2    das Temperaturprofil eines Chip-PLCC 64 und eines Transistors während des Durchgangs durch den Ofen.

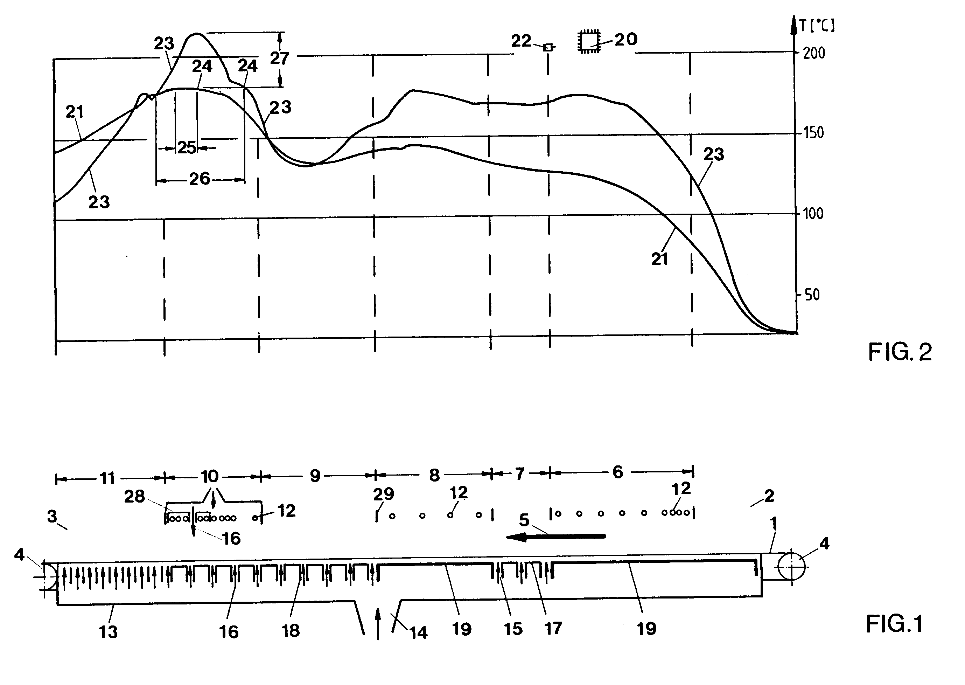

Wie anhand der Figur 1 zu sehen ist, weist der Durchlaufofen ein Transportband 1 auf, das am Eingang 2 und am Ausgang 3 durch jeweils eine Rolle 4 umgelenkt wird. Der Ofen ist in sechs einzelne Zonen unterteilt mit einer in Richtung des Bandlaufes gesehen, der durch den Pfeil 5 angedeutet ist, ersten Aufheizzone 6, einererersten Beruhigungs- oder Kühlzone 7, einer sich daran anschließenden zweiten Aufheizzone 8, einer zweiten Beruhigungs- oder Kühlzone 9, einer Lötzone 10 und einer weiteren Kühlzone 11. Die einzelnen Aufheizzonen 6 und 8 sowie die Lötzone 10 weisen langgestreckte, rohrförmige Infrarot-Strahler 12 auf, die gegebenenfalls paarweise zusammengefaßt sind, wobei die erste Aufheizzone 6 gegenüber der zweiten Aufheizzone 8 mit einer größeren Anzahl an Infrarot-Strahlern 12 bestückt ist und die Lötzone 10 eine gegenüber der ersten Aufheizzone 6 größere Anzahl an Infrarot-Strahlern 12 aufweist. Die von den Infrarot-Strahlern 12 abgegebene Energiedichten betragen in der ersten Aufheizzone 6 etwa 4 W/cm², der zweiten Aufheizzone 8 etwa 2,5 W/cm² und in der Lötzone 10 etwa 5,5 W/cm².

Während die Infrarot-Strahler 12 oberhalb des Transportbandes 1 mit Abstand zu diesem angeordnet sind, sind im Bereich der Unterseite des Transportbandes 1 keine Infrarot-Strahler 12 vorhanden. Mit einem solchen Durchlaufofen werden Leiterplatten, die auf das Transportband 1 aufgelegt werden, verlötet, wobei die zu verlötenden Lötstellen auf der den Infrarot-Strahlern 12 zugewandten Seite der Leiterplatten vorhanden sind, während an der Unterseite keine Lötungen ausgeführt werden. An der Unterseite des Durchlaufofens ist ein Luftverteilungskanal 13 über dessen gesamte Länge vorhanden, dem über einen Zuluftkanal 14 mittels einem nicht dargestelltem Gebläse Kühlluft zugeführt wird. Über den Luftverteilungskanal 13 wird die Kühlluft über die gesamte Länge des Durchlaufofens verteilt, wo sie durch einzelne Düsen 15 in Richtung auf die Unterseite des Transportbandes 1 und damit auf die Unterseite der Leiterplatten gerichtet wird, wie dies durch die Pfeile 16 angedeutet ist. Die Düsen 15 werden zwischen U-Profilen 17 aus Metall gebildet, die mit ihrer Öffnung zwischen den Schenkeln 18 nach unten weisend (es besteht auch die Möglichkeit die Bleche mit ihrer Öffnung nach oben weisend anzuordnen), parallel zueinander und quer zur Laufrichtung 5 des Transportbandes 1 ausgerichtet sind. Die Länge der Schenkel 18 der U-Profile 17 beträgt 60 mm und die Öffnungsbreite der Düsen 15 zwischen benachbarten Schenkeln 18 zweier U-Profile 17 2 mm. Die U-Profile 17 sind in der ersten Beruhigungs- oder Kühlzone 7 sowie in der zweiten Beruhigungs- oder Kühlzone 9 vorgesehen, während die erste Aufheizzone 6 und die zweite Aufheizzone 8 unterhalb des Transportbandes 1 jeweils eine durchgehende Abdeckplatte 19 aufweisen, so daß in diesem Bereich keine Kühlluft auf die vorbeigeführten Leiterplatten strömen kann. Neben der zwangsgekühlten ersten Kühlzone 7 und der zweiten Kühlzone 9 sind an die zweite Kühlzone 9 anschließend im Bereich der Lötzone 10 weitere U-Profile 17 eingesetzt, die auch in der Lötzone 10 Kühlluft auf das Transportband 1 richten.

Leiterplatten, die mit ihren Lötstellen nach oben gerichtet auf das Transportband 1 im Bereich des Eingangs 2 des Durchlaufofens aufgelegt werden, werden zunächst in die erste Aufheizzone 6 eingefahren, wo sie langsam aufgeheizt werden, wie dies anhand der Figur 2 ersichtlich ist. Die beiden Kurven in Figur 2 stellen die Aufheizkurven eines Chip-PLCC 64, mit dem Bezugszeichen 20 bezeichnet, (Kurve 21) und eines wesentlich kleineren Transistors 22 (Kurve 23) dar; der Chip-PLCC 64 sowie der Transistor 22 sind zu Veranschaulichung der Größenverhältnisse nebeneinander in einer Aufsicht gezeigt. Die Masse des Chip-PLCC 64 (Bezugszeichen 20) ist um das 400-fache größer als die Masse des Transistors 22, der drei Anschlußbeine besitzt, während der gemessene Chip-PLCC 64 an vier gegenüberliegenden Seiten jeweils sechzehn Anschlußbeine aufweist. Die Aufheizkurven 21, 23 nach Figur 2 sind dem Durchlaufofen nach Figur 1 direkt zugeordnet.

Die Bauteile 20, 22, die unter Zimmertemperatur auf das Transportband 1 aufgelegt werden, heizen sich in der ersten Aufheizzone 6 mit unterschiedlicher Geschwindigkeit auf, wobei der große Chip-PLCC 64 am Ende der ersten Aufheizzone 6 eine Temperatur von etwa 125 °C im Bereich eines anzulötenden Anschlußbeines besitzt, während der im Vergleich zu dem Chip-PLCC 64 sehr kleine Transistor 22 bereits eine Temperatur von etwa 170 °C besitzt, also eine Temperatur, die geringfügig unterhalb der Löttemperatur von Lötzinn liegt. Die Länge dieser ersten Aufheizzone 6 liegt bei etwa 535 mm, d.h. die Verweildauer in der Aufheizzone 6 beträgt bei einer Bandlaufgeschwindigkeit von etwa 0,8 m/min 40 sec. Nach der Aufheizzone 6 fahren die Leiterplatten mit den zu verlötenden Bauteilen durch die erste Kühlzone 7, in der von der Unterseite über die Düsen 15 zwischen den U-Profilen 17 Kühlluft auf die Leiterplatten strömt. Durch diese Zwangskühlung werden die Leiterplatten und die darauf befindlichen Bauteile gekühlt, wobei der Transistor 22 schneller abkühlt als der wesentlich größere Chip-PLCC 64 (Bezugszeichen 20) mit einer seiner größeren Masse entsprechenden größeren Wärmekapazität mit der Folge, daß die Aufheizkurven 21, 23, die eingangs der ersten Kühlzone 7 um etwa 50 °C beabstandet sind, eingangs der zweiten Aufheizzone 8 noch etwa 35 °C auseinanderliegen. Durch diese erste zwangsgekühlte Kühlzone 7 werden damit die Temperaturen der unterschiedlichen Bauteile einander angeglichen. In der zweiten Aufheizzone 8 werden im Anschluß an die erste Kühlzone 7 die Leiterplatten und die Bauteile weiter aufgeheizt bis sie ausgangs der zweiten Aufheizzone 8 Temperaturen von 180 °C - Kurve 23, Transistor 22 - und 145 °C - Kurve 21, Chip-PLCC 64 - besitzen. Die Länge der ersten Kühlzone 7 beträgt 360 mm, die Durchlaufzeit etwa 26 sec; die Länge der zweiten Aufheizzone 8 beträgt 460 mm mit einer Durchlaufzeit von 35 sec. Nach der zweiten Aufheizzone 8 folgt die zweite Kühlzone 9 mit einer Länge von 430 mm und folglich einer Durchlaufzeit der Leiterplatten von etwa 32 sec. Diese zweite Kühlzone 9 unmittelbar vor der Lötzone 10 bewirkt, daß alle Bauteile abgekühlt werden mit dem Effekt, daß die kleineren Bauteile, wie dies anhand der Kurve 23, der dem Transistor 22 zugeordnet ist, schneller abkühlen als die großen Bauteile und die Temperaturen dieser Bauteile unterschiedlicher Wärmekapazität angeglichen werden, die in dem vorliegenden Beispiel dann bei 125 °C liegen.

In der Lötzone 10, in die nunmehr die Bauteile mit gleicher Temperatur eintreten, findet nun der eigentliche Lötvorgang statt, der unter einer Temperatur von etwa 183 °C einsetzt. Entsprechend der unterschiedlichen Wärmekapazität der Bauteile setzt dieser Lötvorgang bei dem kleinen Transistor 22 früher ein als bei dem großen Chip-PLCC 64; das Erreichen der Löttemperatur von 183 °C ist mit den Punkten 24 gekennzeichnet. Die Länge der Lötzone 10 beträgt 610 mm, die Durchlaufzeit etwa 45 sec. Das Zeitintervall, in dem sich der Chip-PLCC 64 (Bezugszeichen 20) auf einer Löttemperatur befindet, die oberhalb von 183 °C liegt, ist mit dem Bezugszeichen 25 gekennzeichnet, während das entsprechende Zeitintervall für den kleinen Transistor 22 mit 26 gekennzeichnet ist. Die Temperaturdifferenz T zwischen den großen und kleinen Bauteilen, mit dem Bezugzeichen 27 angedeutet, beträgt im Beispiel 31 °C und kann durch Optimierung bzw. durch zusätzliche Kühlung von oben noch weiter verringert werden, wie weiter unten noch ausgeführt wird.

Der Lötzone 10 folgt in Bandlaufrichtung 5 gesehen eine weitere Kühlzone 11, um die Leiterplatten mit den Bauteilen zum Entnehmen aus dem Durchlaufofen ausreichend abzukühlen. Wie die Temperaturkurven zeigen, liegen am Ende des Durchlaufofens die Temperaturen zwischen 100 °C und 135 °C. Auch in dieser weiteren Kühlzone 11 werden die Leiterplatten zwangsgekühlt. Durch Einsatz einer beidseitigen verstärkten Kühlung und/oder Verlängerung der Kühlzone 11 kann die Auslauftemperatur weiter verringert werden.

Um die Leiterplatten in der Lötzone 10 nicht zu überhitzen und um gezielt die Lötstellen der einzelnen Bauteile zu erwärmen, ist auch die Lötzone 10 unterhalb des Transportbandes 1 mit einer Zwangskühlung in Form der bereits beschriebenen U-förmigen Profile 17 ausgestattet.

Gerade in der Lötzone 10 kann ein weiteres Angleichen der Temperaturkurven der unterschiedlichen Bauteile erreicht werden, indem von der Oberseite, also aus Richtung der Infrarot-Strahler 12, eine zusätzliche Kühlung erfolgt. Hierzu sind die Infrarot-Strahler 12 in die Freiräume zwischen den Schenkeln U-förmiger Bleche 28 eingefügt, die, im Gegensatz zu den U-Profilen 17 unterhalb des Transportbandes 1, zum Transportband 1 hin gerichtet sind. Diese U-förmigen Bleche 28 sind in Figur 1 im Bereich der Lötzone 10 nur eingangs dieser Lötzone dargestellt; sie können je nach Erfordernis über die gesamte Lötzone 10 verteilt werden.

Zur Begrenzung der beiden Aufheizzonen 6 und 8 sowie der Lötzone 10 sind in die Ebene der Infrarot-Strahler 12 Abschottbleche 29 eingefügt, die ein seitliches Abstrahlen verhindern.

## Patentansprüche

1. Durchlaufofen zum Anlöten von elektronischen Bauteilen auf Leiterplatten mit einem Transportband (1), das Auflageelemente für die Leiterplatten aufweist, wobei entlang des Transportbandes (1) oberhalb und/oder unterhalb der Bandlaufebene Infrarot-Strahler (12) mit Abstand angeordnet sind, die mehreren Aufheizzonen (6; 8) und, in Richtung des Bandlaufes (5) gesehen, hinter diesen Zonen, einer Lötzone (10) zugeordnet sind, und mit einer Kühlzone, dadurch gekennzeichnet, daß zwischen der letzten Aufheizzone (8) und der Lötzone (10) die Kühlzone (9) angeordnet ist, in der eine Zwangskühlung mit einem gasförmigen Kühlmedium erfolgt, das mittels eines Gebläses durch in der Kühlzone (9) angeordnete Düsen (15) im wesentlichen senkrecht zur Ebene des Transportbandes (1) strömt.

2. Durchlaufofen nach Anspruch 1, dadurch gekennzeichnet, daß zwischen den einzelnen Aufheizzonen (6, 8) jeweils eine Kühlzone (7) angeordnet ist.

3. Durchlaufofen nach Anspruch 2, dadurch gekennzeichnet, daß zwei Aufheizzonen (6, 8) vorgesehen sind.

4. Durchlaufofen nach Anspruch 1 bis 3, dadurch gekennzeichnet, daß die Infrarot-Strahler (12) in Richtung des Bandlaufes (5) gesehen vor dieser Kühlzone (9) enden und nach dieser Kühlzone (9) im Bereich der Lötzone (10) sich fortsetzen.

5. Durchlaufofen nach Anspruch 1 bis 4, dadurch gekennzeichnet, daß die Lötzone (10) eine Zwangskühlung aufweist.

6. Durchlaufofen nach einem der Ansprüche 1 bis 5, dadurch gekennzeichnet, daß die Kühlung in der Lötzone (10) durch ein gasförmiges Kühlmedium mindestens von der den Strahlern (12) gegenüberliegenden Seite des Transportbandes (1) aus erfolgt.

7. Durchlaufofen nach einem der Ansprüche 1 bis 6, dadurch gekennzeichnet, daß die Düsen (15) durch mit Abstand zueinander verlaufende Schenkel (18) von U-Profilen (17) gebildet sind, wobei die U-Profile (17) sich quer zur Laufrichtung (5) des Transportbandes (1) erstrecken.

8. Durchlaufofen nach Anspruch 7, dadurch gekennzeichnet, daß der freie Abstand zwischen benachbarten Schenkeln (18) der U-Profile (17) 1 bis 3 mm beträgt.

9. Durchlaufofen nach Anspruch 7 oder 8, dadurch gekennzeichnet, daß die Länge der Schenkel (18) der U-Profile (17) 40 bis 70 mm beträgt.

10. Durchlaufofen nach einem der Ansprüche 7 bis 9, dadurch gekennzeichnet, daß der mittlere Abstand benachbarter Düsenöffnungen (15) 50 bis 80 mm beträgt.

11. Durchlaufofen nach einem der Ansprüche 1 bis 10, dadurch gekennzeichnet, daß das Transportband (1) mit einer Durchlaufgeschwindigkeit von 0,6 m/min bis 1 m/min betrieben wird.

12. Durchlaufofen nach Anspruch 11, dadurch gekennzeichnet, daß das Transportband (1) mit einer Druchlaufgeschwindigkeit von etwa 0,8 m/min angetrieben wird.

13. Durchlaufofen nach einem der Ansprüche 1 bis 12, dadurch gekennzeichnet, daß die Energiedichte in der ersten Aufheizzone (6) etwa 3,5 bis 4,5 W/cm$^2$ und die Energiedichte in der Lötzone (10) 5 bis 6 W/cm$^2$ beträgt.

14. Durchlaufofen nach einem der Ansprüche 2 bis 13, dadurch gekennzeichnet, daß die Energiedichte In der zweiten Aufheizzone (8) 2 bis 3 W/cm$^2$ beträgt.

15. Durchlaufofen nach einem der Ansprüche 1 bis 14, dadurch gekennzeichnet, daß in der Lötzone (10) kurzwellige Infrarot-Strahler (12) eingesetzt sind.

16. Durchlaufofen nach einem der Ansprüche 1 bis 17, dadurch gekennzeichnet, daß in Bandlaufrichtung (5) nach der Lötzone (10) sich eine zwangsgekühlte Kühlzone (11) anschließt.

17. Durchlaufofen nach Anspruch 1, dadurch gekennzeichnet, daß die eine weitere Kühlzone (9) zwischen der Aufheizzone (8) und der Lötzone (10) eine Länge aufweist, die etwa der Länge der Aufheizzone (8) entspricht.

18. Durchlaufofen nach einem der Ansprüche 1 bis 17, dadurch gekennzeichnet, daß die Kühlzone(n) (7, 9) einzelne Infrarot-Strahler (28) aufweisen.

## Claims

1. A continuous furnace for the soldering of electronic components on printed circuit boards with a conveyor belt (1), which has support elements for the printed circuit boards, in which along the conveyor belt (1), above and/or below the belt running plane, infrared emitters (12) are arranged, spaced apart, which are associated with a plurality of heating zones (6;8) and, viewed in the direction of the belt run (5), behind these zones, are associated with a soldering zone (10), and having a cooling zone, characterised in that between the last heating zone (8) and the soldering zone (10) the cooling zone (9) is arranged, in which an enforced cooling with a gaseous cooling medium takes place, which flows by means of a fan through nozzles (15), arranged in the cooling zone (9), substantially vertically to the plane of the conveyor belt (1).

2. A continuous furnace according to Claim 1, characterised in that a cooling zone (7) is arranged in each case between the individual heating zones (6, 8).

3. A continuous furnace according to Claim 2, characterised in that two heating zones (6, 8) are provided.

4. A continuous furnace according to Claim 1 to 3, characterised in that the infrared emitters (12), viewed in the direction of the belt run (5), end before this cooling zone (9) and continue after this cooling zone (9) in the region of the soldering zone (10).

5. A continuous furnace according to Claim 1 to 4, characterised in that the soldering zone (10) has an enforced cooling.

6. A continuous furnace according to one of Claims 1 to 5, characterised in that the cooling in the soldering zone (10) takes place through a gaseous cooling medium at least from the side of the conveyor belt (1) lying opposite the emitters (12).

7. A continuous furnace according to one of Claims 1 to 6, characterised in that the nozzles (15) are formed by shanks (18) of U-sections (17), running at a distance with respect to each other, in which the U-sections (17) extend transversely to the running direction (5) of the conveyor belt (1).

8. A continuous furnace according to Claim 7, characterised in that the free space between adjacent shanks (18) of the U-sections (17) is 1 to 3 mm.

9. A continuous furnace according to Claim 7 or 8, characterised in that the length of the shanks (18) of the U-sections (17) is 40 to 70 mm.

10. A continuous furnace according to one of Claims 7 to 9, characterised in that the mean distance between adjacent nozzle openings (15) is 50 to 80 mm.

11. A continuous furnace according to one of Claims 1 to 10, characterised in that the conveyor belt (1) is operated at a running speed of 0.6 m/min to 1 m/min.

**12.** A continuous furnace according to Claim 11, characterised in that the conveyor belt (1) is operated at a running speed of approximately 0.8 m/min.

**13.** A continuous furnace according to one of Claims 1 to 12, characterised in that the density of energy in the first heating zone (6) is approximately 3.5 to 4.5 W/cm$^2$ and the, energy density in the soldering zone (10) is 5 to 6 W/cm$^2$

**14.** A continuous furnace according to one of Claims 2 to 13, characterised in that the energy density in the second heating zone (8) is 2 to 3 W/cm$^2$.

**15.** A continuous furnace according to one of Claims 1 to 14, characterised in that in the soldering zone (10) short-wave infrared emitters (12) are used.

**16.** A continuous furnace according to one of Claims 1 to 17, characterised in that in the belt running direction (5), an enforced cooled cooling zone (11) follows after the soldering zone (10).

**17.** A continuous furnace according to Claim 1, characterised in that a further cooling zone (9) between the heating zone (8) and the soldering zone (10) has a length, which corresponds approximately to the length of the heating zone (8).

**18.** A continuous furnace according to one of Claims 1 to 17, characterised in that the cooling zone(s) (7,9) have individual infrared emitters (28).

**Revendications**

**1.** Four à passage continu pour le brasage tendre de composants électroniques sur des plaques à circuits imprimés, comprenant une bande ou tapis de transport (1) qui présente des éléments de support sur lesquels sont disposées les plaques à circuits imprimés, des radiateurs à infrarouge (12) placés à distance les uns des autres le long du tapis de transport (1), au-dessus et/ou au-dessous du plan de défilement du tapis, qui sont coordonnés à plusieurs zones d'échauffement (6; 8) et, derrière ces zones, dans la direction de défilement (5) du tapis, à une zone de brasage (10), ainsi qu'une zone de refroidissement, caractérisé en ce que la zone de refroidissement (9) est disposée entre la dernière zone d'échauffement (8) et la zone de brasage (10) et produit un refroidissement forcé au moyen d'un fluide de refroidissement gazeux qu'un ventilateur souffle à travers des buses (15) placées dans la zone de refroidissement (9) de manière qu'il s'écoule pour l'essentiel perpendiculairement au plan du tapis de transport (1).

**2.** Four à passage continu selon la revendication 1, caractérisé en ce qu'une zone de refroidissement (7) est disposée chaque fois entre les différentes zones d'échauffement (6, 8).

**3.** Four à passage continu selon la revendication 2, caractérisé en ce qu'il comprend deux zones d'échauffement (6, 8).

**4.** Four à passage continu selon les revendications 1 à 3, caractérisé en ce que les radiateurs à infrarouge (12) se terminent devant la zone de refroidissement (9), dans le sens du défilement (5) du tapis, et se prolongent, après cette zone de refroidissement (9), dans la zone de brasage (10).

**5.** Four à passage continu selon les revendications 1 à 4, caractérisé en ce que la zone de brasage (10) comporte un refroidissement forcé.

**6.** Four à passage continu selon une des revendications 1 à 5, caractérisé en ce que le refroidissement dans la zone de brasage (10) est produit, au moyen d'un fluide de refroidissement gazeux, au moins à partir du côté du tapis de transport (1) situé à l'opposé des radiateurs (12).

**7.** Four à passage continu selon une des revendicadtions 1 à 6, caractérisé en ce que les buses (15) sont formées par les ailes (18) placées à distance les unes des autres de profilés en U (17) qui s'étendent transversalement à la direction de défilement (5) du tapis de transport (1).

**8.** Four à passage continu selon la revendication 7, caractérisé en ce que la distance libre entre des ailes (18) voisines des profilés en U (17) est de 1 à 3 mm.

**9.** Four à passage continu selon la revendication 7 ou 8, caractérisé en ce que la longueur des ailes (18) des profilés en U (17) est de 40 à 70 mm.

**10.** Four à passage continu selon une des revendications 7 à 9, caractérisé en ce que l'espacement moyen des ouvertures formant des buses (15) voisines est de 50 à 80 mm.

11. Four à passage continu selon une des revendications 1 à 10, caractérisé en ce que le tapis de transport (1) est entraîné à une vitesse de défilement de 0,6 m/min à 1 m/min.

12. Four à passage continu selon la revendication 1, caractérisé en ce que le tapis de transport (1) est entraîné à une vitesse de défilement d'environ 0,8 m/min.

13. Four à passage continu selon une des revendications 1 à 12, caractérisé en ce que la densité du flux d'énergie dans la première zone d'échauffement (6) est d'environ 3,5 à 4,5 W/cm$^2$ et la densité du flux d'énergie dans la zone de brasage (10) est de 5 à 6 W/cm$^2$.

14. Four à passage continu selon une des revendications 2 à 13, caractérisé en ce que la densité du flux d'énergie dans la deuxième zone d'échauffement (8) est de 2 à 3 W/cm$^2$.

15. Four à passage continu selon une des revendications 1 à 14, caractérisé en ce que les radiateurs à infrarouge (12) utilisés dans la zone de brasage (10) sont à ondes courtes.

16. Four à passage continu selon une des revendications 1 à 15, caractérisé en ce qu'une zone de refroidissement forcé (11) fait suite à la zone de brasage (10) dans la direction de défilement (5) du tapis.

17. Four à passage continu selon la revendication 1, caractérisé en ce que la zone de refroidissement (9) entre la zone d'échauffement (8) et la zone de brasage (10) possède une longueur qui correspond à peu près à la longueur de cette zone d'échauffement (8).

18. Four à passage continu selon une des revendications 1 à 17, caractérisé en ce que la ou les zone(s) de refroidissement (7, 9) entre les zones d'échauffement comportent des radiateurs à infrarouge (28) individuels.

FIG. 2

FIG.1

EP 0 315 762 B1